(19) Europäisches Patentamt
European Patent Office
Office européen des brevets

(11) **EP 2 421 154 B1**

(12) **EUROPÄISCHE PATENTSCHRIFT**

(45) Veröffentlichungstag und Bekanntmachung des Hinweises auf die Patenterteilung:
**02.07.2014  Patentblatt 2014/27**

(51) Int Cl.:
***H03L 7/185*** *(2006.01)*     ***H03L 7/23*** *(2006.01)*

(21) Anmeldenummer: **11006843.4**

(22) Anmeldetag: **22.08.2011**

(54) **Schaltungsanordnung zur Erzeugung von eine breitbandige Frequenzrampe bildenden hochfrequenten Ausgangssignalen**

Switch assembly for generating high frequency output signals comprising a broadband frequency ramp

Agencement de commutation pour la production de signaux de sortie à haute fréquence formant une rampe de fréquence à large bande

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.08.2010   DE 102010035243**

(43) Veröffentlichungstag der Anmeldung:
**22.02.2012   Patentblatt 2012/08**

(73) Patentinhaber: **KROHNE Messtechnik GmbH 47058 Duisburg (DE)**

(72) Erfinder:
• **Pohl, Nils, Dr.-Ing.
44801 Bochum (DE)**
• **Musch, Thomas, Prof. Dr.-Ing.
44879 Bochum (DE)**

(74) Vertreter: **Gesthuysen Patent- und Rechtsanwälte Patentanwälte
Postfach 10 13 54
45013 Essen (DE)**

(56) Entgegenhaltungen:
**US-A- 3 696 422     US-A- 5 642 066**

EP 2 421 154 B1

**Beschreibung**

Die Erfindung betrifft eine Schaltungsanordnung zur Erzeugung von eine breitbandige Frequenzrampe bildenden hochfrequenten Ausgangssignalen, mit einem Referenzoszillator, einem Phasendetektor, vorzugsweise einem Schleifenfilter, einem VC-Oszillator zur Erzeugung der Ausgangssignale, einem Frequenzteiler, einem Abwärtsmischer und einem Lokaloszillator zur Erzeugung eines Lokaloszillatorsignals, wobei der Referenzoszillator, der Phasendetektor, gegebenenfalls das Schleifenfilter, der VC-Oszillator, der Frequenzteiler und der Abwärtsmischer zu einem Phasenregelkreis gehören, der Frequenzteiler und der Abwärtsmischer im Rückkoppelpfad des Phasenregelkreises liegen, der Abwärtsmischer die Ausgangssignale und das Lokaloszillatorsignal mischt und die Frequenz des Ausgangssignals durch Variation des Teilungsverhältnisses des Frequenzteilers einstellbar ist.

Schaltungsanordnungen zur Erzeugung von eine breitbandige Frequenzrampe bildenden hochfrequenten Ausgangssignalen sind vielfach bekannt (vergleiche die deutschen Offenlegungsschriften 100 65 657 und 10 2004 032 130, die USA-Patentschrift 5,642,066 und die USA-Offenlegungsschrift 2008/0061891 sowie die Literaturstellen "A High Precision 24-GHz FMCW Radar Based on a Fractional-N Ramp-PLL", IEEE TRANSACTIONS ON INSTRUMENTA-TION AND MEASUREMENT, VOL. 52, NO. 2, April 2003, "SiGe Bipolar VCO With Ultra-Wide Tuning Range at 80 GHz Center Frequency", IEEE JOURNAL OF SOLID-STATE CIRCUITS, VOL. 44, NO. 10, Oct. 2009).

Bekannt ist im Übrigen aus der USA-Patentschrift 3,696,422 eine Schaltungsanordnung mit einem Referenzoszillator, einem Phasendetektor, einem Schleifenfilter, einem spannungsgesteuerten Oszillator - hiernach abgekürzt "VC-Oszillator" - zur Erzeugung der Ausgangssignale, einem Festfrequenzteiler mit einem festen Teilungsverhältnis, einem Abwärtsmischer, einem Lokaloszillator zur Erzeugung eines Lokaloszillatorsignals und einem Frequenzteiler mit einem variablen Teilungsverhältnis bekannt. Der Referenzoszillator, der Phasendetektor, das Schleifenfilter, der VC-Oszillator, der Festfrequenzteiler mit festem Teilungsverhältnis, der Abwärtsmischer und der Frequenzteiler mit einem variablen Teilungsverhältnis gehören zu einem Phasenregelkreis, wobei der Frequenzteiler mit einem festen Teilungsverhältnis, der Abwärtsmischer und der Frequenzteiler mit einem variablen Teilungsverhältnis im Rückkopplungspfad des Phasenregelkreises liegen. Der Abwärtsmischer mischt die vom Festfrequenzteiler mit festem Teilungsverhältnis geteilten Ausgangssignale und das Lokaloszillatorsignal und die Frequenz des Ausgangssignals ist durch Variation des Teilungsverhältnisses des Frequenzteilers mit einem variablen Teilungsverhältnis einstellbar.

Schaltungsanordnungen der eingangs beschriebenen Art, also solche zur Erzeugung von eine breitbandige Frequenzrampe bildenden hochfrequenten Ausgangssignalen werden für moderne FMCW-Radarsysteme, also für das frequenuzmodulierte Dauerstrichradar, für Entfemungs- und Geschwindigkeitsmessungen mit hoher Genauigkeit, Auflösung und Dynamik verwendet. Die Abkürzung FMCW entstammt dem englischen Begriff Frequency Modulated Continues Wave (vergleiche Wikipedia "FMCW-Radar").

Für FMCW-Radarsysteme werden Schaltungsanordnungen benötigt, deren hochfrequente Ausgangssignale periodisch, linear auf- oder / und absteigende Frequenz haben. Die hochfrequenten Ausgangssignale einer Schaltungsanordnung der in Rede stehenden Art, deren Frequenz periodisch, linear auf- oder / und absteigende Frequenzen haben, sind weiter oben mit Frequenzrampe bezeichnet worden und werden auch weiter mit Frequenzrampe bezeichnet.

Für Anwendungen mit hoher Ortsauflösung und guter Antennenbündelung sind in den letzten Jahren Frequenzbänder im Millimeterwellenbereich standardisiert worden. Für automobile Anwendungen ist das Frequenzband von 76 GHz bis 81 GHz freigegeben, und für die industrielle Füllstandsmessung ist sogar ein 10 GHz breites Frequenzband von 75 GHz bis 85 GHz freigegeben.

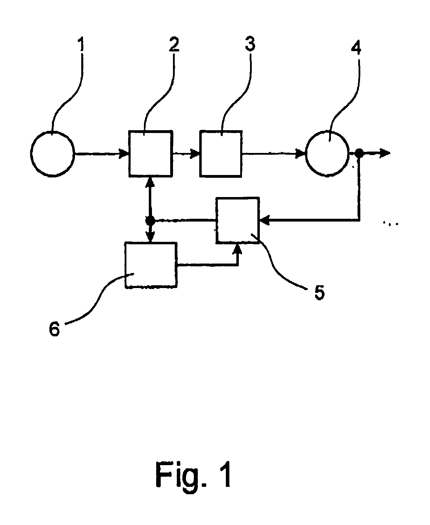

Die Fig. 1 zeigt eine zum Stand der Technik gehörende Schaltungsanordnung der in Rede stehenden Art mit einem Referenzoszillator 1, einem Phasendetektor 2, einem Schleifenfilter 3, einem spannungsgesteuerten Oszillator, also einem VC-Oszillator 4 zur Erzeugung der hochfrequenten Ausgangssignale, einem Frequenzteiler 5 und einer Steuereinheit 6.

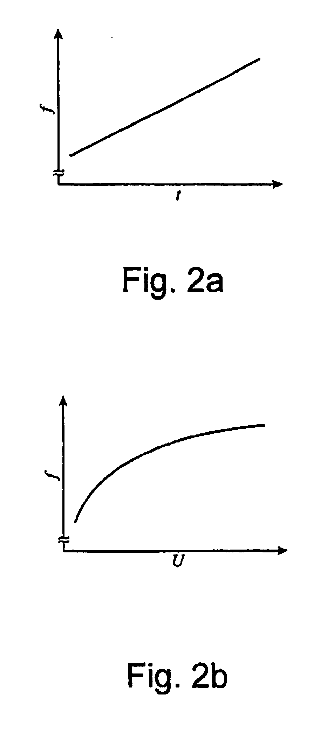

Die Fig. 2a zeigt die gewünschte lineare Frequenzrampe der hochfrequenten Ausgangssignale, also die Frequenz f der Ausgangssignale über der Zeit t. Dem gegenüber zeigt die Fig. 2b einen typischen, nichtlinearen Verlauf der Abstimmkennlinie eines VC-Oszillators.

Bei der in der Fig. 1 dargestellten, zum Stand der Technik gehörenden Schaltungsanordnung ist als Referenzoszillator 1 ein Quarzoszillator vorgesehen und bilden der Phasendetektor 2, das Schleifenfilter 3, der VC-Oszillator 4, der Frequenzteiler 5 und die Steuereinheit 6 einen Phasenregelkreis (übliche englische Abkürzung: PLL). Bei der Schaltungsanordnung nach der Fig. 1 ist eine gewöhnliche, einschleifige PLL realisiert. Dabei wird unter der Annahme einer stabilen Regelung mit dem Schleifenfilter 3 die Differenzphase der beiden Eingangssignale am Phasendetektor 2 zu Null geregelt.

Nachfolgend soll der reziproke Wert des Teilungsfaktors mit N bezeichnet werden. Es entspricht also die Ausgangsfrequenz am Frequenzteiler 5 dem N-fachen der Eingangsfrequenz:

$$f_A = N \cdot f_E$$

Zur Erzeugung der Frequenzrampe wird, im einfachsten Fall, durch die Steuereinheit 6 der Frequenzteiler 5 mit jedem Takt um einen Wert erhöht. Durch die glättende Tiefpasscharakteristik des Schleifenfilters 3 ergibt sich daraus eine linearisierte Frequenzrampe. Die Verwendung von fraktionalen Teilerfaktorsequenzen erlaubt auch die Variation um rationale Werte und ermöglicht dadurch einen weiteren Freiheitsgrad bei der Wahl der Steigung der Frequenzrampe bzw. deren Dauer.

Im folgenden sollen nun die Regel- und Stabilitätseigenschaften des zuvor angesprochenen Phasenregelkreises anhand der Ringverstärkung betrachtet werden:

Für den Phasendetektor 2 ergibt sich eine mittlere Ausgangsspannung, welche mit $K_{PD}$ proportional zur Phasendifferenz der beiden Eingangssignale ist, also des vom Referenzoszillator 1 kommenden Eingangssignals und des vom Frequenzteiler 5 kommenden Eingangssignals. Die Ausgangsspannung des Phasendetektors 2 wird im Schleifenfilter 3 gefiltert und dem VC-Oszillator 4 als dessen Eingangsspannung zugeführt. Der VC-Oszillator 4 gibt dann hochfrequente Ausgangssignale ab, deren Frequenz von der Eingangsspannung, also der vom Phasendetektor 2 kommenden Ausgangsspannung, gefiltert durch das Schleifenfilter 3, entspricht. Der Zusammenhang zwischen der Eingangsspannung am VC-Oszillator 4 und der Frequenz der hochfrequenten Ausgangssignale des VC-Oszillators 4 ist in der Fig. 2b dargestellt.

Der Zusammenhang zwischen der Eingangsspannung am VC-Oszillator 4 und der Frequenz der hochfrequenten Ausgangssignale des VC-Oszillators 4 kann, linearisiert um eine Arbeitsfrequenz, durch einen proportionalen Faktor $K_{VCO}$ beschrieben werden. Für den VC-Oszillator 4 ergibt sich also, bezogen auf seine Ausgangsphase mit $K_{VCO}/s$ ein integrales Verhalten. Nimmt man den Teilungsfaktor des Frequenzteilers 5 im Phasenregelkreis, also im Rückkoppelpfad, hinzu, ergibt sich die Ringverstärkung des gesamten Regelkreis zu:

$$H_{ring}(s) = K_{PD} \cdot F(s) \cdot \frac{K_{VCO}}{s} \cdot \frac{1}{N} \cdot$$

Um auch sprungförmige Frequenzfehler und damit linear ansteigende Phasenfehler ausregeln zu können, muss das Schleifenfilter 3 ein überwiegend integrales Verhalten aufweisen. Da aber durch die inhärente Integration des VC-Oszillators 4 die Phasenreserve schon auf 90° reduziert wird, muss für die Dimensionierung des Schleifenfilters 3 bei der Durchtrittsfrequenz der Ringverstärkung durch phasenanhebende Glieder die Phasenreserve erhöht werden. In diesem Frequenzbereich weicht dann allerdings das Schleifenfilter 3 von dem integralen Verhalten ab, wodurch sich eine schlechte Regelung ergibt, insbesondere eine schlechtere Störundrückung des eingangsseitigen Phasenrauschens. Aus diesem Grund sollte dieser Frequenzbereich mit erhöhter Phasenreserve nur einen schmalen Bereich um die Durchtrittsfrequenz abgrenzen, was nur möglich ist, wenn die Ringverstärkung innerhalb der Frequenzrampe konstant ist.

Wird der Phasenregelkreis zur Erzeugung einer Frequenzrampe durch Umschalten des Teilungsfaktors N im Rückkoppelpfad verwendet, bewirkt dies eine Variation der Ringverstärkung. Einerseits geht der Teilungsfaktor N direkt in die Ringverstärkung ein, andererseits bewirkt die geänderte Ausgangsfrequenz eine Änderung der Abstimmsteilheit des VC-Oszillators 4 (vergleiche die Fig. 2b). Ungünstigerweise wirken beide Effekte in dieselbe Richtung und verstärken sich somit gegenseitig. Bei tiefen Frequenzen hat der VC-Oszillator 4 gemäß der Fig. 2b die höchste Abstimmsteilheit, welche durch den kleinsten Wert des Teilungsfaktors N dividiert wird. Dem gegenüber wird bei hohen Frequenzen eine kleine Abstimmsteilheit durch einen großen Teilungsfaktor N dividiert. Dies kann zu einer Variation der Ringverstärkung um mehr als den Faktor 10:1 führen.

Generell ist es zwar möglich, das Schleifenfilter 3 so zu dimensionieren, dass sich auch bei einer großen Variation der Ringverstärkung eine robuste Regelung ergibt, allerdings müssen dann Abstriche bei den übrigen Regeleigenschaften, insbesondere bei der Stabilisierung des trägemahen Phasenrauschens in Kauf genommen werden.

Im Stand der Technik sind Ansätze bekannt, die durch eine nichtlineare Verzerrung der Eingangsspannung am VC-Oszillator 4 die Ringverstärkung konstant halten. Dies kann entweder durch digitale oder analoge Schaltungen erfolgen (vergleiche die USA-Offenlegungsschrift 2008/0,061,891 bzw. die USA-Patentschrift 5,642,066), wodurch sich beinahe beliebige, nichtlineare Formen, abhängig von dem gewählten Konzept des PLL, kompensieren lassen. Allerdings erfordern sehr breitbandige Frequenzrampen auch VC-Oszillatoren mit einer sehr großen Abstimmbandbreite, was nur durch eine große Abstimmsteilheit zu realisieren ist. Diese große Abstimmsteilheit bewirkt, dass schon marginale Störungen der Abstimmspannung, also der Eingangsspannung am VC-Oszillator, wie sie jede analoge oder digitale Schaltung unweigerlich hervorruft, eine Modulation der Frequenz der hochfrequenten Ausgangssignale verursachen, so dass in PLLs für breitbandige Frequenzrampen der Pfad vom Phasendetektor 2 bis zum VC-Oszillator 4 sehr ungünstig zum Einbringen zusätzlicher Schaltungen ist.

Unter Berücksichtigung dessen, was zuvor ausgeführt worden ist, liegt der Erfindung die Aufgabe zugrunde, die Schaltungsanordnung zur Erzeugung von eine breitbandige Frequenzrampe bildenden hochfrequenten Ausgangssignalen, von der die Erfindung ausgeht, mit dem Ziel zu verbessern, eine bessere Linearität der Frequenz der hochfrequenten Ausgangssignale zu erzielen.

Die erfindungsgemäße Schaltungsanordnung, bei der die zuvor hergeleitete und aufgezeigte Aufgabe gelöst ist, ist als kern der Erfindung dadurch gekennzeichnet, dass mit Hilfe der einstellbaren Frequenz des Lokaloszillators die Kennlinie des Ausgangssignals verbessert wird, und zwar dadurch, dass als Abwärtsmischer ein Kehrlagenmischer derart eingebracht ist, dass sich in der Ringverstärkung des Phasenregelkreises die Variationen des Teilungsfaktors mit der Abstimmsteilheit des spannungsgesteuerten Oszillators kompensieren. Dies ermöglicht die Stabilisierung des VC-Oszillators in einem sehr weiten Frequenzbereich mit guten Regeleigenschaften. Besonders für den Einsatz bei hohen Frequenzen, also im Millimeterwellenbereich, zum Beispiel im Bereich von 80 GHz, ist aufgrund der grundsätzlich schlechteren Rauscheigenschaften des VC-Oszillators eine gute Stabilisierung notwendig.

Bei der erfindungsgemäßen Schaltungsanordnung kann der Lokaloszillator spannungsgesteuert sein, er kann auch mit einem Phasenregelkreis ausgestattet sein.

Nach einer weiteren Lehre der Erfindung hat der Frequenzteiler ein variables Teilungsverhältnis und ist die Frequenz des Lokaloszillatorsignals durch den Frequenzteiler mit variable Teilungsverhältnis im Rückkoppelpfad des Phasenregelkreises des Lokaloszillators einstellbar. Auch kann der Phasenregelkreis des Lokaloszillators als Referenz einen eigenen Referenzoszillator aufweisen oder den primär notwendigen Referenzoszillator mit verwenden.

Im übrigen ist bei der erfindungsgemäßen Schaltungsanordnung vorzugsweise die Frequenz des Lokaloszillators höher als die Frequenz des Eingangssignals des Abwärtsmischers, also die Frequenz des VC-Oszillators.

Für die bauteilmäßige Realisierung erfindungsgemäßer Schaltungsanordnungen bietet es sich an, den VC-Oszillator und den Lokaloszillator als integrierte Schaltungen mit integrierten LC-Resonatorelementen zu realisieren. Kostengünstig ist eine Ausführungsform, bei der zumindest der VC-Oszillator und der Lokaloszillator auf demselben Chip realisiert sind. Außerdem empfiehlt es sich, den Lokaloszillator durch einen zusätzlichen Phasenregelkreis zu stabilisieren.

Zu der Schaltungsanordnung, von der die Erfindung ausgeht, folglich auch zu der erfindungsgemäßen Schaltungsanordnung gehört, wie ausgeführt, ein Frequenzteiler. Es kann sich aber anbieten, das insgesamt gewünschte Frequenzteilerverhältnis durch den ohnehin vorgesehenen Frequenzteiler und einen zusätzlichen Frequenzvorteiler - zwischen dem VC-Oszillator und dem Abwärtsmischer - zu realisieren.

Sind der VC-Oszillator und der Lokaloszillator auf demselben Chip realisiert und ist, wie zuvor dargestellt, zusätzlich ein Frequenzvorteiler vorgesehen, dann empfiehlt es sich, den Frequenzvorteiler auf dem Chip zu realisieren, auf dem auch der VC-Oszillator und der Lokaloszillator realisiert sind. Schließlich kann auch noch zusätzlich der Abwärtsmischer auf dem Chip realisiert sein, auf dem der VC-Oszillator und der Lokaloszillator, gegebenenfalls auch der Frequenzvorteiler, realisiert sind.

Die zuvor als bevorzugt beschriebene Hochintegration minimiert einerseits die Kosten durch eine verringerte Zahl an Schnittstellen und ermöglicht andererseits eine stromsparende Realisierung, die die zusätzlichen Kosten für die Spannungsversorgung und die Kühlung gering halten und Anwendungen mit streng limitiertem Energiebudget ermöglicht. Insbesondere in der industriellen Messtechnik wird die zur Verfügung stehende elektrische Leistung bei Verwendung eines 2-Draht-Einheitssignals stark limitiert.

Im einzelnen gibt es nun verschiedene Möglichkeiten, die erfindungsgemäße Schaltungsanordnung auszugestalten und weiterzubilden. Dazu wird verwiesen auf die dem Patentanspruch 1 nachgeordneten Patentansprüche 2 bis 11 und auf die in der Zeichnung dargestellten Ausführungsbeispiele. Es zeigen

Fig. 3     schematisch, ein bevorzugtes Ausführungsbeispiel einer erfindungsgemäßen Schaltungsanordnung zur Erzeugung von eine breitbandige Frequenzrampe bildenden hochfrequenten Ausgangssignalen,

Fig. 4     grafische Darstellung zur Erläuterung des der Erfindung zugrundeliegenden Prinzips und

Fig. 5     nochmals ein bevorzugtes Ausführungsbeispiel einer Schaltungsanordnung zur Erzeugung von eine breitbandige Frequenzrampe bildenden hochfrequenten Ausgangssignalen.

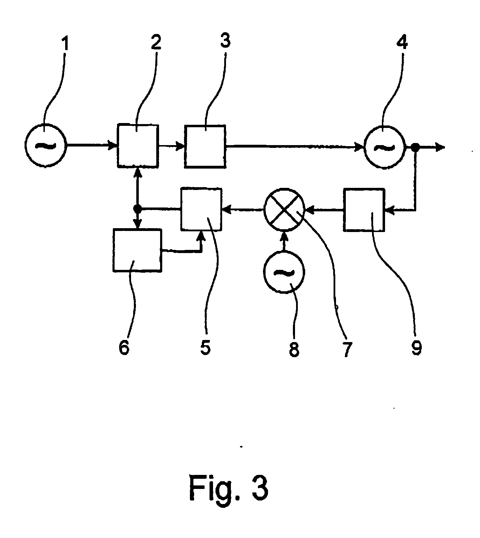

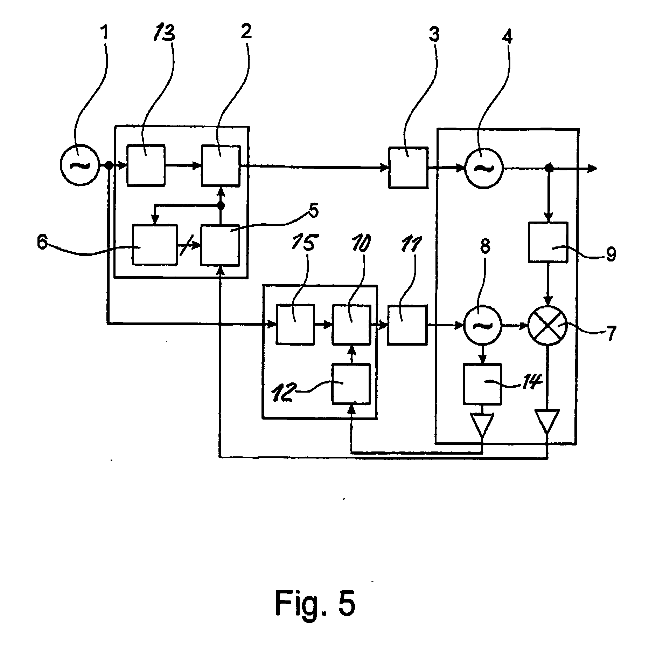

Die Figuren 3 und 5 zeigen bevorzugte Ausführungsbeispiele erfindungsgemäßer Schaltungsanordnungen zur Erzeugung von eine breitbandige Frequenzrampe bildenden hochfrequenten Ausgangssignalen. Zu diesen Schaltungsanordnungen gehören ein Referenzoszillator 1, ein Phasendetektor 2, ein Schleifenfilter 3, ein spannungsgesteuerter Oszillator, also ein VC-Oszillator 4 zur Erzeugung der hochfrequenten Ausgangssignale, ein Frequenzteiler 5 mit einer zugeordneten Steuereinheit 6, mit der der Teilungsfaktor N des Frequenzteilers 5 eingestellt werden kann, ein Abwärtsmischer 7 und ein Lokaloszillator 8 zur Erzeugung eines Lokaloszillatorsignals. Dabei gehören der Referenzoszillator 1, der Phasendetektor 2, das Schleifenfilter 3, der VC-Oszillator 4 der Frequenzteiler 5 und der Abwärtsmischer 7 zu einem Phasenregelkreis, liegen der Abwärtsmischer 7 und der Frequenzteiler 5 im Rückkoppelpfad des Phasenregelkreises, mischt der Abwärtsmischer 7 das Ausgangssignal des VC-Oszillators 4 und das Lokaloszillatorsignal und ist die Frequenz des Ausgangssignals, also des Ausgangssignals des VC-Oszillators 4, durch Variation des Teilungsverhältnisses des Frequenzteilers 5 einstellbar, nämlich mittels der Steuereinheit 6.

Die erfindungsgemäße Schaltungsanordnung ist zunächst und im wesentlichen dadurch gekennzeichnet, dass mit Hilfe der einstellbaren Frequenz des Lokaloszillatorsignals die Kennlinie des Ausgangssignals verbessert wird, nämlich linearisiert werden kann, und zwar dadurch, dass als Abwärtsmischer 7 ein Kehrlagenmischer derart eingebracht ist, dass sich in der Ringverstärkung des Phasenregelkreises die Variationen des Teilungsfaktors mit der Abstimmsteilheit des VC-Oszillators 4 kompensieren.

Für das Ausführungsbeispiel in Fig. 3 gilt ergänzend, dass zusätzlich zu dem Frequenzteiler 5 ein Frequenzvorteiler 9 vorgesehen ist, und zwar zwischen dem VC-Oszillator 4 und dem Abwärtsmischer 7. Wird zum Beispiel die Schaltungsanordnung insgesamt so dimensioniert, dass das Ausgangssignal des VC-Oszillators 4 eine Frequenz von 80 GHz hat, dann kann es vorteilhaft sein, den Frequenzvorteiler 9 so zu realisieren, dass das Ausgangssignal des Frequenzvorteilers 9 = das Eingangssignal des Abwärtsmischers 7 nur 20 GHz beträgt, und dass, ohne eine Beeinflussung durch den Abwärtsmischer 7, aus dem Eingangssignal am Frequenzteiler 5 mit 20 GHz ein Ausgangssignal von 20 MHz gewonnen wird. Der "gesamte Frequenzteiler" im Rückkoppelpfad besteht also aus dem hochfrequenten, festen Frequenzvorteiler 9 und dem niederfrequenten, programmierbaren Frequenzteiler 5.

Bei dem Ausführungsbeispiel nach Fig. 3 befindet sich zwischen dem Frequenzvorteiler 9 und dem Frequenzteiler 5 der - von der Steuereinheit 6 programmierbare - Abwärtsmischer 7.

Allgemein finden Mischer in Phasenregelkreisen häufig Anwendung, da hierdurch das trägernahe Phasenrauschen des VC-Oszillators 4 reduziert werden kann. Der gewöhnliche Ansatz eines Gleichlagemischers würde aufgrund der größeren relativen Änderung der Werte des Frequenzteilers 5 die Variation der Ringverstärkung in der PLL sogar erheblich vergrößern, weshalb bei der erfindungsgemäßen Schaltungsanordnung ein Abwärtsmischer in Kehrlage verwendet ist. Die für einen einfachen Phasenregelkreis weiter oben angegebene Formel der Ringverstärkung bleibt in der hier betrachteten, linearisierten Form bestehen. Lediglich der Teilungsfaktor N muss durch das Produkt P - N ersetzt werden. Allerdings muss beachtet werden, dass sich nun bei der großen Abstimmsteilheit, also bei kleinen Frequenzen, große Teilungsfaktoren ergeben, so dass es zu einem Kompensationseffekt kommt. Die Dimensionierung der Frequenz des Lokaloszillatorsignals bleibt als Freiheitsgrad zur Erzielung eines optimalen Kompensationseffektes.

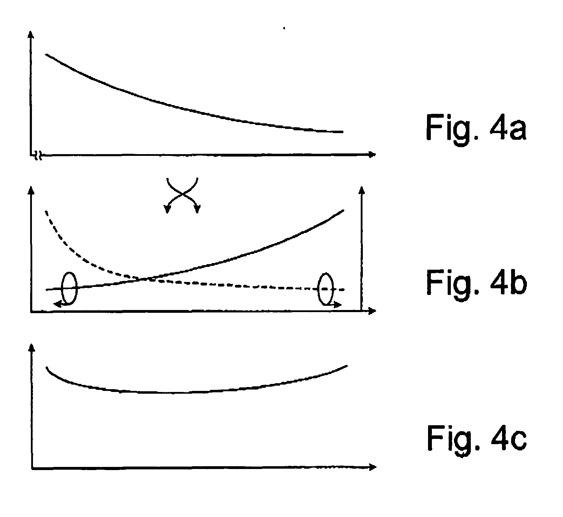

Die Fig. 4 zeigt das, was erfindungsgemäß erreicht worden ist:

    Die Fig. 4a zeigt die Abstimmsteilheit des VC-Oszillators 4 über der Frequenz, welche durch den Abwärtsmischer 7 in Kehrlage in der Frequenz gespiegelt wird, was die Fig. 4b zeigt, so dass diese einen entgegengesetzten Verlauf zum reziproken Wert des Teilungsfaktors aufweist. Die Fig. 4c zeigt eine schematische Darstellung des resultierenden Verlaufs des Quotienten aus Abstimmsteilheit und Rückkoppelteilungsfaktor bei optimaler Wahl der Frequenz des Lokaloszillatorsignals.

Die Fig. 5 zeigt ein besonders bevorzugtes Ausführungsbeispiel einer erfindungsgemäßen Schaltungsanordnung zur Erzeugung von eine breitbandige Frequenzrampe bildenden hochfrequenten Ausgangssignalen. Bei diesem Ausführungsbeispiel sind zunächst, wie auch beim Ausführungsbeispiel nach Fig. 3, ein Referenzoszillator 1, ein Phasendetektor 2, ein Schleifenfilter 3, ein VC-Oszillator 4, ein Frequenzteiler 5, eine dem Frequenzteiler 5 zugeordnete Steuereinheit 6, ein Abwärtsmischer 7, ein Lokaloszillator 8 und ein Frequenzvorteiler 9 vorgesehen. Mit dem in Fig. 5 dargestellten Ausführungsbeispiel einer erfindungsgemäßen Schaltungsanordnung wird eine hochlineare Frequenzrampe mit einer Bandbreite erreicht, wie sie in der Literatur nicht annähernd beschrieben ist.

Im Ausführungsbeispiel nach Fig. 5 ist der Lokaloszillator 8, wie der VC-Oszillator 4, spannungsgesteuert und mit einem Phasenregelkreis ausgestattet, zu dem ein Phasendetektor 10, ein Schleifenfilter 11 und ein Frequenzteiler 12 gehören. Durch den Frequenzvorteiler 9 mit einem Teilungsfaktor von 4 sind die Arbeitsfrequenz des Abwärtsmischers 7 und des Lokaloszillators 8 so verringert, dass deren Realisierung mit geringem Aufwand möglich ist. Die Ausgangsfrequenzen zur Stabilisierung des VC-Oszillators 4 und des Lokaloszillators 8 liegen unterhalb von 7 GHz, so dass die PLLs mit einer breiten Auswahl an kostengünstigen, kommerziellen PLL-Modulen realisiert werden können. Zur Rampenerzeugung wird der Frequenzteiler 5 in der PLL des VC-Oszillators 4 (fraktional) variiert, während die PLL des Lokaloszillators 8 bei einer festen Frequenz arbeitet und für gutes Phasenrauschen mit einer hohen Referenzfrequenz betrieben werden kann.

Im übrigen sind im Ausführungsbeispiel nach Fig. 5 noch weitere Frequenzteiler 13, 14 und 15 vorgesehen, deren Funktion für den Fachmann ohne weiteres ersichtlich ist.

Erste Labormuster der erfindungsgemäßen Schaltungsanordnung haben die Funktion des Systemkonzeptes bestätigt und eine Stabilisierung des VC-Oszillators 4 in beinahe dessen gesamtem Abstimmbereich mit einer Abstimmbandbreite von über 22 GHz bei gleichzeitig gutem Phasenrauschen ermöglicht. Durch Temperatur- und Fertigungsschwankungen ist in der Praxis eine Reduzierung des Abstimmbereichs zu erwarten. Die Variation der Ringverstärkung ist so gering, dass diese beim Entwurf für das Schleifenfilter 3 vernachlässigt wurde, so dass dieses auf gutes Phasenrauschen optimiert werden konnte. Die realisierte Schaltungsanordnung hatte eine Stromaufnahme von lediglich 100 mA bei einer Spannungsversorgung von 5 V.

**Patentansprüche**

1. Schaltungsanordnung zur Erzeugung von eine breitbandige Frequenzrampe bildenden hochfrequenten Ausgangssignalen, mit einem Referenzoszillator, einem Phasendetektor, vorzugsweise einem Schleifenfilter, einem spannungsgesteuerten Oszillator- hiernach abgeführt VC-Oszillator- zur Erzeugung der Ausgangssignale, einem Frequenzteiler, einem Abwärtsmischer und einem Lokaloszillator zur Erzeugung eines Lokaloszillatorsignals, wobei der Referenzoszillator, der Phasendetektor, gegebenenfalls das Schleifenfilter, der VC-Oszillator, der Frequenzteiler und der Abwärtsmischer zu einem Phasenregelkreis gehören, der Frequenzteiler und der Abwärtsmischer im Rückkoppelpfad des Phasenregelkreises liegen, der Abwärtsmischer die Ausgangssignale und das Lokaloszillatorsignal mischt und die Frequenz des Ausgangssignals durch Variation des Teilungsverhältnisses des Frequenzteilers einstellbar ist,
**dadurch gekennzeichnet,**
**dass** mit Hilfe der einstellbaren Frequenz des Lokaloszillatorsignals die Kennlinie des Ausgangssignals verbessert wird, und zwar dadurch, dass als Abwärtsmischer (7) ein Kehrlagemischer derart eingebracht ist, dass sich in der Ringverstärkung des Phasenregelkreises die Variationen des Teilungsfaktors mit der Abstimmsteilheit des VC-Oszillators (4) kompensieren.

2. Schaltungsanordnung nach Anspruch 1, **dadurch gekennzeichnet, dass** der Lokaloszillator (8) spannungsgesteuert ist.

3. Schaltungsanordnung nach Anspruch 2, **dadurch gekennzeichnet, dass** der Lokaloszillator (8) mit einem Phasenregelkreis ausgestattet ist.

4. Schaltungsanordnung nach Anspruch 3, **dadurch gekennzeichnet, dass** der Frequenzteiler (5) ein variables Teilungsverhältnis hat und dass die Frequenz des Lokaloszillatorsignals durch den Frequenzteiler (5) mit variablen Teilungsverhältnis im Rückkoppelpfad des Phasenregelkreises des Lokaloszillators (8) einstellbar ist.

5. Schaltungsanordnung nach Anspruch 3 oder 4, **dadurch gekennzeichnet, dass** der Phasenregelkreis des Lokaloszillators (8) als Referenz einen eigenen Referenzoszillator besitzt oder den primären Referenzoszillator (1) mit benutzt.

6. Schaltungsanordnung nach einem der Ansprüche 1 bis 5, **dadurch gekennzeichnet, dass** die Frequenz des Lokaloszillatorsignals höher ist als die Frequenz des Eingangssignals des Abwärtsmischers (7).

7. Schaltungsanordnung nach einem der Ansprüche 1 bis 6, **dadurch gekennzeichnet, dass** der VC-Oszillator (4) und der Lokaloszillator (8) als integrierte Schaltungen mit integrierten LC-Resonatorelementen realisiert sind.

8. Schaltungsanordnung nach einem der Ansprüche 1 bis 7, **dadurch gekennzeichnet, dass** zumindest der VC-Oszillator (4) und der Lokaloszillator (8) auf demselben Chip realisiert sind.

9. Schaltungsanordnung nach einem der Ansprüche 1 bis 8, **dadurch gekennzeichnet, dass** ein Frequenzvorteiler (9) zwischen dem VC-Oszillator (4) und dem Abwärtsmischer (7) vorgesehen ist.

10. Schaltungsanordnung nach Anspruch 8 und 9, **dadurch gekennzeichnet, dass** zusätzlich auch der Frequenzvorteiler (9) auf demselben Chip realisiert ist.

11. Schaltungsanordnung nach einem der Ansprüche 8 bis 10, **dadurch gekennzeichnet, dass** zusätzlich auch der Abwärtsmischer (7) auf demselben Chip realisiert ist.

**Claims**

1. Circuit arrangement for generating high frequency output signals which form a broadband frequency ramp, having a reference oscillator, a phase detector, preferably a loop filter, a voltage-controlled oscillator - hereafter abbreviated as VC oscillator - for generating the output signal, a frequency divider, a step-down mixer and a local oscillator for generating a local oscillator signal, wherein the reference oscillator, the phase detector, possibly the loop filter, the VC oscillator, the frequency divider and the step-down mixer belong to a phase-locking loop, the frequency divider and the step-down mixer are located in a feedback path of the phase-locking loop, the step-down mixer mixes the output signals and the local oscillator signals and the frequency of the output signal is adjustable by variation of a division ratio of the frequency divider,
**characterized in**
**that** the characteristic curve of the output signal is improved with the help of the adjustable frequency of the local oscillator signal in that an inverted-position mixer as step-down mixer (7) is introduced in such a manner that in the ring gain of the phase-locking loop, the variations of the division factor are compensated with the tuning steepness of the VC oscillator (4).

2. Circuit arrangement according to claim 1, **characterized in that** the local oscillator (8) is voltage-controlled.

3. Circuit arrangement according to claim 2, **characterized in that** the local oscillator (8) is equipped with a respective phase-locking loop.

4. Circuit arrangement according to claim 3, **characterized in that** the frequency divider (5) has a variable division ratio and that the frequency of the local oscillator signals is adjustable by the frequency divider (5) with variable division ratio in the feedback path of the phase-locking loop of the local oscillator (8).

5. Circuit arrangement according to claim 3 or 4, **characterized in that** the phase-locking loop of the local oscillator (8) has its own reference oscillator as a reference or uses the primary reference oscillator (1) at the same time.

6. Circuit arrangement according to any one of claims 1 to 5, **characterized in that** the frequency of the local oscillator signal is greater than the frequency of the input signal of the step-down mixer (7).

7. Circuit arrangement according to any one of claims 1 to 6, **characterized in that** the VC oscillator (4) and the local oscillator (8) are implemented as integrated circuits with integrated LC resonator elements.

8. Circuit arrangement according to any one of claims 1 to 7, **characterized in that** at least the VC oscillator (4) and the local oscillator (8) are implemented on the same chip.

9. Circuit arrangement according to any one of claims 1 to 8, **characterized in that** a frequency prescaler (9) is provided between the VC oscillator (4) and the step-down mixer (7).

10. Circuit arrangement according to claim 8 or 9, **characterized in that** the frequency prescaler (9) is additionally also implemented on the same chip.

11. Circuit arrangement according to any one of claims 8 to 10, **characterized in that** the step-down mixer (7) is additionally also implemented on the same chip.

**Revendications**

1. Arrangement de circuit pour générer des signaux de sortie à haute fréquence formant une rampe de fréquence à large bande, comprenant un oscillateur de référence, un détecteur de phase, de préférence un filtre à boucle, un oscillateur commandé en tension - abrégé ici par oscillateur VC - pour générer les signaux de sortie, un diviseur de fréquence, un mélangeur abaisseur et un oscillateur local pour générer un signal d'oscillateur local, l'oscillateur de référence, le détecteur de phase, le cas échéant le filtre à boucle, l'oscillateur VC, le diviseur de fréquence et le mélangeur abaisseur faisant partie d'un circuit de régulation de phase, le diviseur de fréquence et le mélangeur abaisseur se trouvant dans le trajet de rétroaction du circuit de régulation de phase, le mélangeur abaisseur mélangeant les signaux de sortie et le signal d'oscillateur local et la fréquence du signal de sortie pouvant être réglée en faisant varier le rapport cyclique du diviseur de fréquence, **caractérisé en ce que** la courbe caractéristique du signal de sortie est améliorée à l'aide de la fréquence réglable du signal d'oscillateur local par le fait que le mélangeur abaisseur (7) est un mélangeur à point d'inversion qui est inséré de telle sorte que les variations du facteur de division avec la pente d'accord de l'oscillateur VC (4) sont compensées dans l'amplification de boucle du circuit de régulation de phase.

2. Arrangement de circuit selon la revendication 1, **caractérisé en ce que** l'oscillateur local (8) est commandé en tension.

3. Arrangement de circuit selon la revendication 2, **caractérisé en ce que** l'oscillateur local (8) est équipé d'un circuit de régulation de phase.

4. Arrangement de circuit selon la revendication 3, **caractérisé en ce que** le diviseur de fréquence (5) présente un rapport cyclique variable et **en ce que** la fréquence du signal d'oscillateur local peut être réglée par le diviseur de fréquence (5) à rapport cyclique variable dans le trajet de rétroaction du circuit de régulation de phase de l'oscillateur local (8).

5. Arrangement de circuit selon la revendication 3 ou 4, **caractérisé en ce que** le circuit de régulation de phase de l'oscillateur local (8) possède comme référence un oscillateur de référence propre ou utilise également l'oscillateur de référence principal (1).

6. Arrangement de circuit selon l'une des revendications 1 à 5, **caractérisé en ce que** la fréquence du signal d'oscillateur local est supérieure à la fréquence du signal d'entrée du mélangeur abaisseur (7).

7. Arrangement de circuit selon l'une des revendications 1 à 6, **caractérisé en ce que** l'oscillateur VC (4) et l'oscillateur local (8) sont réalisés sous la forme de circuits intégrés avec des éléments résonateurs LC intégrés.

8. Arrangement de circuit selon l'une des revendications 1 à 7, **caractérisé en ce qu'**au moins l'oscillateur VC (4) et l'oscillateur local (8) sont réalisés sur la même puce.

9. Arrangement de circuit selon l'une des revendications 1 à 8, **caractérisé en ce qu'**un pré-diviseur de fréquence (9) est prévu entre l'oscillateur VC (4) et le mélangeur abaisseur (7).

10. Arrangement de circuit selon les revendications 8 et 9, **caractérisé en ce que** le pré-diviseur de fréquence (9) est en plus lui aussi réalisé sur la même puce.

11. Arrangement de circuit selon l'une des revendications 8 à 10, **caractérisé en ce que** le mélangeur abaisseur (7) est en plus lui aussi réalisé sur la même puce.

Fig. 1

Fig. 2a

Fig. 2b

Fig. 3

Fig. 4a

Fig. 4b

Fig. 4c

Fig. 5

**EP 2 421 154 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10065657
- DE 102004032130
- US 5642066 A
- US 20080061891 A
- US 3696422 A

**In der Beschreibung aufgeführte Nicht-Patentliteratur**

- A High Precision 24-GHz FMCW Radar Based on a Fractional-N Ramp-PLL. *IEEE TRANSACTIONS ON INSTRUMENTA-TION AND MEASUREMENT,* April 2003, vol. 52 (2
- SiGe Bipolar VCO With Ultra-Wide Tuning Range at 80 GHz Center Frequency. *IEEE JOURNAL OF SOL-ID-STATE CIRCUITS,* Oktober 2009, vol. 44 (10